(19) Europäisches Patentamt
European Patent Office
Office européen des brevets

(11) **EP 2 779 031 B1**

(12) **EUROPÄISCHE PATENTSCHRIFT**

(45) Veröffentlichungstag und Bekanntmachung des Hinweises auf die Patenterteilung:
**15.05.2019 Patentblatt 2019/20**

(51) Int Cl.:
***G06K 7/00*** *(2006.01)*   ***G06K 7/10*** *(2006.01)*
*G01R 31/28* *(2006.01)*

(21) Anmeldenummer: **14000837.6**

(22) Anmeldetag: **10.03.2014**

(54) **Messverfahren und Messvorrichtung**

Measuring method and device

Procédé de mesure et dispositif de mesure

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.03.2013   DE 102013004194**

(43) Veröffentlichungstag der Anmeldung:
**17.09.2014   Patentblatt 2014/38**

(73) Patentinhaber: **Giesecke+Devrient Mobile Security GmbH**
**81677 München (DE)**

(72) Erfinder:
• **Baldischweiler, Michael**
**81825 München (DE)**
• **Auracher, Ulrich**
**83607 Holzkirchen (DE)**

(56) Entgegenhaltungen:
**EP-A2- 0 289 830        EP-A2- 2 722 794**
**WO-A1-2013/034293    US-A1- 2012 264 373**

**Beschreibung**

Die vorliegende Erfindung betrifft ein Verfahren und eine Messvorrichtung zum Messen einer Eigenschaft eines zur kontaktlosen Datenkommunikation eingerichteten Schwingkreises. Der Schwingkreis umfasst vorzugsweise eine Antenne, insbesondere eine induktiv koppelnde Antennenspule mit mindestens einer Windung, und ein mit der Antenne gekoppeltes elektronisches Bauteil, also insbesondere einen RFID- oder NFC-Chip.

Um die Funktionsfähigkeit einer kontaktlosen Chipkarte während oder nach der Herstellung des Schaltkreises aus Antenne und Chip zu prüfen, sind verschiedene Verfahren bekannt. Bei einer solchen Prüfung wird im Wesentlichen geprüft, ob die Antennenspule einen Bruch aufweist und/oder ob zwei oder mehr Spulenwindungen der Antenne versehentlich kurzgeschlossen sind. Mängel dieser Art beeinträchtigen die Funktionsfähigkeit der Antennenspule erheblich bzw. zerstören diese vollständig. Eine Prüfung des Schaltkreises, bestehend aus der Antenne und dem mit der Antenne verbundenen elektronischen Bauteil, kann auch die Funktionsfähigkeit des Bauteils oder einzelner Komponenten des Bauteils betreffen.

Eine Prüfung der Antennenspule kann in Form einer Gleichstrom-Widerstandsmessung erfolgen. Ein solches Prüfverfahren ist aufwendig, da eine Kontaktierung der Antennenspule erforderlich ist. Weiterhin können nur bestimmte Fehler des geprüften Schaltkreises erkannt werden. Eine Fehlfunktion eines oder mehrerer Komponenten des elektronischen Bauteils oder ein Leiterbahnbruch in bestimmten Bereichen der Antenne sind auf diese Weise nicht oder kaum erkennbar.

Alternativ können die Resonanzfrequenz der Antennenspule und deren Güte kontaktlos bestimmt werden. Dazu wird in der Regel ein Phasen- und Impedanz-Analysator verwendet. Ein solches, sehr aufwendiges Verfahren ist detailliert beispielsweise im "RFID-Handbuch" von Klaus Finkenzeller, 6. Auflage, Carl Hanser Verlag, München, 2012, in Kapitel 4.1.11.2, beschrieben. Liegt die gemessene Resonanzfrequenz in einem vorgegebenen Bereich, so ist die Antennenspule funktionsfähig. Diese Art der Prüfung ist aussagekräftiger als eine rein ohmsche Messung, allerdings ungleich aufwendiger. Die Zeitdauer einer solchen Prüfung liegt im Bereich von mehreren Sekunden und erfordert eine komplexe Messvorrichtung.

Aus der EP 0 289 830 A2 ist ein Verfahren zur Messung eines Schwingkreises bekannt, der zur kontaktlosen Datenkommunikation eingesetzt wird. Hierzu wird der Schwingkreis durch eine statische Messvorrichtung mit einem Energiepuls angeregt und die abklingende Schwingung erfasst. Die unabhängigen Ansprüche sind gegen dieses Dokument abgegrenzt.

Die US 2012/264373 A1 beschreibt ein Verfahren zur Detektion eines Schwingkreises, welcher mit einer Sprungfunktion angeregt wird und dessen abklingende Schwingung anschließend erfasst wird.

Aufgabe der vorliegenden Erfindung ist es, ein Verfahren und eine Messvorrichtung zur schnellen, einfach durchzuführenden und kostengünstigen Prüfung eines zur kontaktlosen Datenkommunikation eingerichteten Schwingkreises vorzuschlagen.

Diese Aufgabe wird durch ein Verfahren und eine Messvorrichtung mit den Merkmalen der unabhängigen Ansprüche gelöst. Vorteilhafte Ausgestaltungen und Weiterbildungen der Erfindung sind in den abhängigen Ansprüchen angegeben.

Ein Grundgedanke des vorliegenden Verfahrens besteht darin, den zu prüfenden Schwingkreis mittels eines Energiepulses zur Schwingung anzuregen und die durch die Anregung erzeugte (abklingende) Schwingung des Schwingkreises, welche einer freien, gedämpften Schwingung entspricht, zu erfassen und auszuwerten. Aus der erfassten Schwingung können dann, wie nachfolgend im Detail beschrieben, Eigenschaften des Schaltkreises abgelesenen und geprüft werden, wie beispielsweise die Eigenresonanzfrequenz oder die Güte des Schaltkreises.

Das vorliegende Verfahren zum Messen einer Eigenschaft eines zur kontaktlosen Datenkommunikation vorgesehenen Schwingkreises mit einer Messvorrichtung, umfasst die folgenden Schritte. Die Messvorrichtung wird zu dem Schwingkreis hin geführt. Der Schwingkreis wird durch die Messvorrichtung mittels eines Energiepulses angeregt. Eine abklingende Schwingung des Schwingkreises in Antwort auf die Anregung durch den Energiepuls wird mit der Messvorrichtung erfasst.

Der Schwingkreis umfasst eine Antenne und vorzugsweise ein daran angeschlossenes Bauelement, insbesondere in der Form eines Chips. Der Schwingkreis ist für eine induktiv koppelnde Datenkommunikation ausgebildet, wie sie beispielsweise als RFID- oder NFC-Kommunikation bekannt ist. Die Antenne des Schwingkreises ist als planare Spulenantenne mit vorzugsweise mindestens einer Windung ausgebildet. Auch die Erregerantenne und die Messantenne der Messvorrichtung sind als induktiv koppelnde Antennen ausgebildet. Der Schwingkreis bzw. Schaltkreis, wie er im Folgenden teilweise bezeichnet wird, ist zur Kommunikation nach ISO/IEC 14443 und /oder ISO/IEC 15693 eingerichtet sein.

Das weitere Erfassen eines durch das Führen der Messvorrichtung entstandenen Messparameters kann für eine Auswertung der erfassten Schwingung und/oder für eine Rückmeldung zum Führen an die Instanz, welche die Messvorrichtung führt, verwendet werden.

Der Messparameter betrifft erfindungsgemäß eine Bewegung der Messvorrichtung. In einem nicht von der Erfindung gedeckten Beispiel betrifft der Messparameter eine Lage der Messvorrichtung zu dem ersten Schwingkreis. Die Lage der Messvorrichtung umfasst insbesondere den Abstand der Messvorrichtung zum Schwingkreis und/oder die Lage der Ebene der Messantenne (und der Errgerantenne) zu der Lage der Ebene der Antenne des Schwingkreises.

Das Auswerten der erfassten Schwingung des Schwingkreises hinsichtlich der Eigenschaft des Schwingkreises kann unter Verwendung des Messparameters erfolgen.

Insbesondere wenn in einem Messvorgang mehrere Schwingkreise gemessen werden, erfolgen entsprechend nacheinander Messungen mit den Teilmessschritten des Anregens und Erfassens für jeden zu messenden Schwingkreis. Das Führen der Messvorrichtung zu dem nächsten Schwingkreis hin kann dabei wie ein weiterer Teilschritt der jeweiligen Messungen betrachtet werden.

Mittels der erfassten Bewegung kann insbesondere der gemessene Schwingkreis aus mehreren gemessenen Schwingkreisen bestimmt werden, falls das Bewegungsmuster unbekannt oder nicht mit hinreichender Sicherheit vorbestimmt ist.

Wird der Messparameter in dem Schritt des Auswertens mit berücksichtigt, müssen die Randbedingungen der Messung nicht notwendigerweise so genau eingehalten werden, wie es ohne diesen Schritt erforderlich wäre. So kann die Auswertung beispielsweise den erfassten tatsächlichen Abstand zum gemessenen Schwingkreis oder eine Abweichung der Ebene der Messantenne zum gemessenen Schwingkreis berücksichtigen. Ein Referenzwert (für einen Vergleich) oder der Messwert kann im Rahmen der Auswertung durch den Messparameter korrigiert werden.

Eine Verwendung des Messparameters, um ein Rückmeldungssignal zu erzeugen, ermöglicht es, die Führung der Messeinrichtung zu beeinflussen. Diese Rückmeldung kann insbesondere bereits in der Messvorrichtung erzeugt und ausgegeben werden. Zur Ausgabe einer Rückmeldung an einen Benutzer der Vorrichtung können optische, akustische oder mechanische Rückmeldeeinheiten dienen.

Vorteilhaft erfolgt das Anregen des Schwingkreises als induktives Anregen mittels eines gepulsten Magnetfeldes erfolgt, wobei das Magnetfeld vorzugsweise durch einen einzelnen Strompuls erzeugt wird und/oder wobei der Strompuls vorzugsweise als Gleichstrompuls in Form eines Dirac-Stoßes erzeugt wird. In der Regel wird das Anregen des Schwingkreises kontaktlos mittels einer Erregerantenne durchgeführt. Ebenso wird das Erfassen der Schwingung des Schwingkreises kontaktlos mittels einer Messantenne durchgeführt.

Die Messvorrichtung zum Messen eines zur kontaktlosen Datenkommunikation eingerichteten Schwingkreises umfasst neben einem Griff, welcher für das Messen des Schwingkreises die Führung der Messvorrichtung zu dem Schwingkreis ermöglicht, eine Erregerantenne für ein kontaktloses Anregen des Schwingkreises und eine Messantenne, die eingerichtet ist, eine abklingende Schwingung des Schwingkreises in Antwort auf die Anregung mittels der Erregerantenne zu erfassen. Bevorzugt ist auch ein Impulsgeber, der den Energiepuls erzeugt in der Messvorrichtung enthalten.

Die Messvorrichtung umfasst ferner einen Sensor zur Erfassung eines durch die Führung der Messvorrichtung entstandenen Messparameters. Als Sensor können ein Beschleunigungssensor, ein Abstandssensor und/oder ein Lagesensor dienen.

Die Rückmeldeeinheit erzeugt eine Rückmeldung als Steuersignal oder als für einen Benutzer wahrnehmbares Signal. Die Rückmeldung betrifft die geführte Bewegung der Messvorrichtung.

Die Messvorrichtung ist eine tragbare Einheit. Die Mess- und Auswertungsvorrichtung (oder Prüfvorrichtung) umfasst neben der Messvorrichtung auch eine Auswertungseinheit. Die Auswertungseinheit kann stationär oder aber beweglich, beispielsweise mit einem eigenen Griff, ausgebildet sein.

Die erfasste Schwingung des Schaltkreises wird schließlich ausgewertet, insbesondere hinsichtlich einer Eigenresonanzfrequenz und/oder Güte des Schaltkreises. Dies kann mittels einer Auswertungseinrichtung erfolgen, die mit der Messantenne verbunden ist.

Die Auswertungseinrichtung kann dabei insbesondere einen Vergleich mit Referenzwerten einer intakten Antennenspule heranziehen. Zur Analyse der von der Messantenne beim Erfassen der Schwingung, d.h. der freien, gedämpften Schwingung, erfassten Signale kann in bekannter Weise beispielsweise ein digitaler Signalprozessor (DSP) dienen.

Ein durch einen Energiepuls angeregter Schaltkreis schwingt nach der Anregung grundsätzlich unmittelbar mit einer freien, gedämpften Schwingung A(t) aus, welche mit der folgenden Formel beschrieben werden kann:

$$A(t) = A_0(t)\, e^{\,(-\,\delta t)} \cos \omega t.$$

A(t) kann dabei dem Strom I oder der Spannung U eines durch den Schaltkreis gebildeten elektrischen Schwingkreises entsprechen. Demnach kann der Spannungsverlauf des Schaltkreises unmittelbar nach der Anregung mit der folgenden Formel beschrieben werden:

$$U(t) = U_0(t)\, e^{\,(-\,\delta t)} \cos \omega t$$

Die Kreisfrequenz $\omega$ entspricht dabei der Eigenresonanzfrequenz des Schaltkreises fres multipliziert mit $2\,\pi$ ($\omega = 2\,\pi$ fres). Aus dem Abklingkoeffizienten $\delta$ und der Eigenresonanzfrequenz $f_{res}$ kann die Güte Q des Schaltkreises ermittelt werden. Alternativ kann die Güte Q auch aus zwei aufeinander folgenden Maxima $A_n$ und $A_{n+1}$ der Schwingungsamplitude des Schaltkreises ermittelt werden.

$$Q = \frac{\pi * f_{res}}{\delta} = \frac{\pi}{\ln(\frac{A_n}{A_{n+1}})}$$

Je länger der Abklingvorgang dauert, desto höher ist die Güte des entsprechenden Schwingkreises. D.h. eine Auswertung der freien, gedämpften Schwingung des Schaltkreises, d. h. deren Ausschwingen unmittelbar nach der Anregung, erlaubt es, sowohl die Eigenresonanzfrequenz als auch die Güte des Schaltkreises zu bestimmen.

Ein Aspekt der Erfindung beruht nun auf dem Umstand, dass ein Defekt der Antenne des zu prüfenden Schaltkreises, wie beispielsweise eine Unterbrechung einer Leiterbahn oder ein Kurzschluss zwischen einzelnen Spulenwindungen einer als Antennenspule ausgebildeten Antenne, dazu führt, dass sich ein bei einer beschriebenen Prüfung erkennbarer Signalverlauf des Ausschwingens signifikant von einem entsprechenden Signalverlauf des Ausschwingens einer intakten Antennenspule unterscheidet. Anhand der ausgewerteten freien, gedämpften Schwingung festgestellte Parameter einer fehlerhaften Antenne, insbesondere deren Eigenresonanzfrequenz und deren Güte, unterscheiden sich deutlich von den entsprechenden Parametern einer intakten Antenne.

Ein Leiterbahnbruch beispielsweise zeigt sich in einem deutlich erkennbar veränderten Ausschwingverhalten, insbesondere einer veränderten, in der Regel erhöhten Eigenresonanzfrequenz. Im Falle eines Kurzschlusses von zwei oder mehr Spulenwindungen ist kaum mehr ein Ausschwingen zu beobachten.

Auf diese Weise kann beim Auswerten der freien, gedämpften Schwingung durch die Prüfvorrichtung nicht nur erkannt werden, ob die Antennenspule fehlerhaft ist oder nicht, sondern es kann im Falle eines Fehlers oder Mangels auch der Typ des Fehlers bzw. die Art des Mangels festgestellt werden.

Die Vorteile des erfindungsgemäßen Verfahrens sind offensichtlich und zahlreich. Die Prüfung des Schaltkreises, insbesondere der Antenne des Schaltkreises, kann kontaktlos und mit sehr geringem Zeitaufwand erfolgen. Dies erlaubt für geeignete Ausführungsformen von Schaltkreisen eine Prüfung während eines laufenden Produktionsprozesses. Insbesondere kann auch bereits eine gedruckte Antennenspule, welche noch nicht vollständig ausgehärtet ist, mit dem erfindungsgemäßen Verfahren geprüft werden. Die benötigte Messvorrichtung ist vergleichsweise einfach und kostengünstig bereitzustellen. Zudem erlaubt das Verfahren nicht nur, Fehler oder Mängel einer defekten Antenne des Schaltkreises zu erkennen, sondern auch verschiedene Fehlertypen eines zu prüfenden Schaltkreises zu unterscheiden.

Grundsätzlich sollte eine Messantenne der betreffenden Art, d.h. eine Messantenne, die eingerichtet ist, eine Schwingung, beispielsweise eines gemäß dem erfindungsgemäßen Verfahren angeregten Schaltkreises, zu erfassen, bestimmte technischen Eigenschaften zeigen. Eine solche Messantenne sollte derart ausgebildet sein, dass sie selbst durch ihre physikalischen Eigenschaften eine Messung, beispielsweise einer Schwingung eines Schaltkreises, nicht oder nur unwesentlich beeinflusst. Dazu sollte die Messantenne möglichst breitbandig ausgelegt sein und lediglich eine sehr gering ausgeprägte Spannungsüberhöhung im Bereich ihrer Resonanzfrequenz aufweisen. Insbesondere sollte ein Ausschwingen der Messantenne, beispielsweise in Reaktion auf eine Anregung, im Wesentlichen unterdrückt werden.

Im Rahmen des erfindungsgemäßen Prüfverfahrens und mit Bezug auf eine erfindungsgemäße Messvorrichtung werden die Erregerspule und die Messantenne der Messvorrichtung. In dem Fall, dass die Erregerspule und die Messantenne nicht orthogonal zueinander, sondern beispielsweise nebeneinander angeordnet sind, wird der Erregungspuls der Erregerspule auch von der Messantenne erfasst. Zudem überlagert dann das Abschwingverhalten der Erregerspule das zu messende Abschwingverhalten der Antennenspule.

Bei einer "orthogonalen" Anordnung der Erregerspule zu der Messantenne liegen diese derart zueinander, dass das Signal der Erregerspule von der Messantenne nicht wahrgenommen wird. Die Erregerspule ist dabei gegenüber der Messantenne räumlich so angeordnet, dass in der Messantenne im Wesentlichen kein Signal eingekoppelt wird. Ein Signal wird in eine Spule immer dann eingekoppelt, wenn das Ringintegral über den magnetischen Fluss $\Phi$ durch diese Spule größer als Null ist (vgl. oben zitiertes RFID-Handbuch, Kapitel 4.1.6 und 4.1.9.2). Das Integral über den magnetischen Fluss $\Phi$ ist genau dann Null, wenn sich magnetische Feldlinien unterschiedlicher Richtung und Feldstärke in der Messantenne über die Gesamtfläche gegenseitig aufheben, oder wenn der Winkel der Feldlinien zur Spulenachse genau 90° beträgt - daher der Begriff "orthogonale" Anordnung. Eine geeignete, so genannte koplanare orthogonale Anordnung der Erregerspule zur Messantenne kann beispielsweise derart erfolgen, dass die beiden Antennen in einer Ebene geeignet teilweise übereinander liegen.

Vorzugsweise ist an die Messantenne der Messvorrichtung unmittelbar ein Verstärker angeordnet. Dadurch kann eine lange, kapazitätsbelegte Zuleitung vermieden werden. Der Verstärker umfasst bevorzugt einen hochohmigen Eingang. Als Verstärker kann beispielsweise ein Impedanzwandler verwendet werden. Dessen Ausgangsimpedanz ist dann vorzugsweise an ein Übertragungsmittel angepasst, welches den Impedanzwandler mit der Auswertungseinrichtung verbindet. Als Verbindungsmittel wird vorzugsweise ein Koaxialkabel verwendet. In diesem Fall beträgt die Ausgangsimpedanz des Impedanzwandlers 50 $\Omega$.

Wie erwähnt, wird im Zusammenhang mit der bevorzugten Ausführungsform des erfindungsgemäßen Verfahrens im Schritt des Auswertens der wie vorstehend beschrieben, erfassten oder ermittelten freien, gedämpften Schwingung des Schaltkreises insbesondere die Eigenresonanzfrequenz des Schaltkreises und die Güte des Schaltkreises in Abhängigkeit von der Feldstärke des vorliegenden magnetischen Wechselfeldes ermittelt. Daraus können, wie beschrieben, in vielfältiger Weise Rückschlüsse auf die Funktionsfähigkeit bzw. die Eigenschaften des Schaltkreises gezogen werden.

Die vorliegende Erfindung wird nachfolgend mit Bezug auf die beiliegenden Zeichnungen beispielhaft beschrieben. Darin zeigen:

Figur 1 eine funktionale Darstellung der an einer Messung beteiligten Einheiten;

Figur 2 den Verlauf einer freien, gedämpften Schwingung;

Figur 3 Schritte einer bevorzugten Ausführungsform eines Mess- und Auswertungsverfahrens zum Prüfen eines zur kontaktlosen Datenkommunikation eingerichteten Schwingkreises;

Figur 4 mögliche Bewegungsmuster bei der aufeinander folgenden Prüfung mehrerer Schwingkreise;

Figur 5 eine bevorzugte Ausführungsform der tragbaren Mess- und Auswertungsvorrichtung; und

Figur 6 eine bevorzugte Ausführungsform der tragbaren Mess- und Auswertungsvorrichtung.

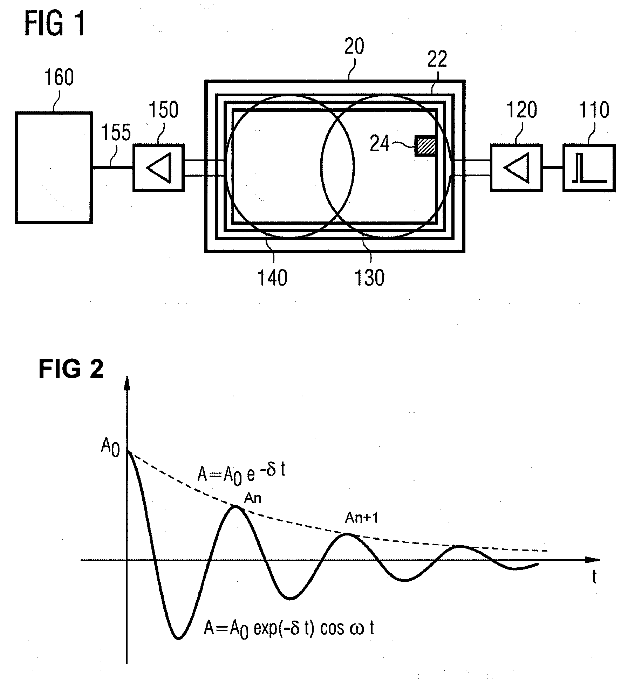

Der in Figur 1 exemplarisch dargestellte Messaufbau dient zum Prüfen eines zur kontaktlosen Datenkommunikation eingerichteten Schaltkreises 20 als Schwingkreis. Dieser Schwingkreis 20 umfasst eine Antennenspule 22, welche mindestens eine Windung umfasst, und ein elektronisches Bauteils 24, beispielsweise ein RFID-Chip. Antennenspule 22 und Bauteil 24 sind auf einem nicht leitenden Träger angeordnet. Die Antennenspule 22 ist eine induktiv koppelnde Antennenspule.

Der Messaufbau umfasst einen Impulsgeber 110, der vorzugsweise über einen Verstärker 120 mit einer Erregerspule 130 verbunden ist. Mittels eines durch den Impulsgeber 110 erzeugten Energiepulses, vorzugsweise in Form eines Dirac-Stoßes, kann der zu prüfende Schaltkreis 20 über die Erregerspule kontaktlos angeregt werden.

Eine Messantenne 140 ist eingerichtet, eine Schwingung des zu prüfenden Schaltkreises 20 zu erfassen und vorzugsweise über einen Verstärker 150 an eine Auswertungseinrichtung 160 weiterzuleiten. Erregerspule 130 und Messantenne 140 sind für die Messung in geeignetem, vorzugsweise geringem Abstand neben der Antenne 22 des zu prüfenden Schaltkreises 20 angeordnet. Die Messantenne 140 erfasst die in Antwort auf die Anregung durch den Energiepuls abklingende Schwingung des Schaltkreises 20.

Wie in Fig. 1 durch die teilweise überlappende Anordnung angedeutet, sind die Messantenne 140 und Erregerspule 130 dabei orthogonal zueinander angeordnet. Dies hat, wie vorstehend beschrieben, die Auswirkung, dass in die Messantenne 140 möglichst kein Signal der Erregerspule 130 eingekoppelt wird. Die Erregerspule 130 und die Messantenne 140 können auf einem geeigneten, flächigen Träger angeordnet werden.

Um eine günstige Signalauskopplung zu erreichen, sollte das mittels der Messantenne 140 erfasste Signal möglichst hochohmig ausgekoppelt werden. Daher wird unmittelbar an die Messantenne 140, wie in Figur 1 dargestellt, ein Verstärker 150 mit hochohmigem Eingang angeordnet. Vorzugsweise wird als Verstärker 150 ein Impedanzwandler eingesetzt. Dieser besitzt vorzugsweise eine Ausgangsimpedanz von 50Ω und ist mittels eines Koaxialkabels 155 mit der Auswertungseinrichtung 160 verbunden. Dieses sollte dabei vorzugsweise eine Eingangsimpedanz von 50 Ω aufweisen. Damit können Reflexionen wirkungsvoll vermieden werden.

Figur 2 zeigt den theoretischen Verlauf einer freien, gedämpften Schwingung $A(t)$ im Verlauf der Zeit $t$. Die Funktion $A(t)$ kann dabei dem Strom $I$ oder der Spannung $U$ entsprechen. Die Kreisfrequenz $\omega$ entspricht der Eigenresonanzfrequenz des entsprechenden Schaltkreises 20 multipliziert mit $2\pi$. Aus dem Abklingkoeffizienten $\delta$ kann die Güte des Schaltkreises 20 bestimmt werden. Eine entsprechend abklingende Schwingung entsteht in Antwort auf die vorliegende Anregung mittels eines Energiepulses.

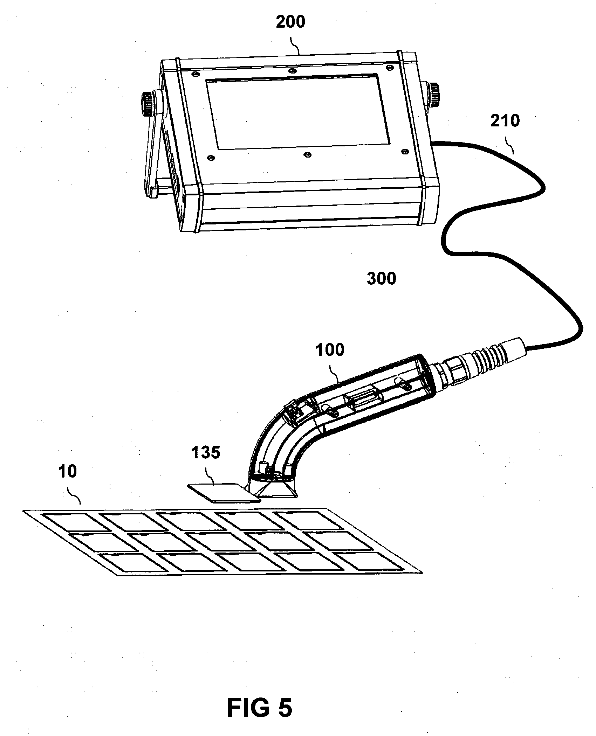

Figur 5 zeigt eine tragbare Prüfvorrichtung 300, welche eine an einem Griff führbare Messvorrichtung 100 und eine Auswertungseinheit 200 umfasst. Die Messvorrichtung 100 ist über ein flexibles Kabel 210 oder kabellos (beispielsweise via Bluetooth) mit der Auswertungseinheit 200 verbunden. Auf einem Antennenträger 135 der Messvorrichtung 100 sind die Messantenne und die Erregerantenne angeordnet (nicht dargestellt). Die hier ebenfalls nicht dargestellten Einheiten aus Fig. 1, also der Impulsgeber 110 und die Verstärker 120 und 150 sind vorzugsweise ebenfalls in der Messvorrichtung 100 angeordnet. Von Interesse ist, dass die Messvorrichtung 100 - unabhängig von der Auswertungseinheit 200 - bewegbar ist.

Die Messvorrichtung 100 kann somit über einen Bogen 10 mit mehreren Schwingkreisen geführt werden, um die Schwingkreise nacheinander zu prüfen. Für die Messung wird die Messvorrichtung 100 so über den Bogen 10 geführt, dass der Antennenträger 135 der Messvorrichtung 100, auf welchem die Messantenne und die Erregerantenne angeordnet sind (nicht dargestellt), optimal zu dem gerade zu messenden Schwingkreis angeordnet ist. Bevorzugt soll die Messvorrichtung parallel mit einem vorgegebenen minimalen Abstand zum Schwingkreis (ohne Berührung) geführt werden. Die Messvorrichtung 100 umfasst Mittel zur Erfassung eines Messparameters, der aus der geführten Bewegung der Messvorrichtung 100 entsteht, beispielsweise in der Form eines Beschleunigungssensors.

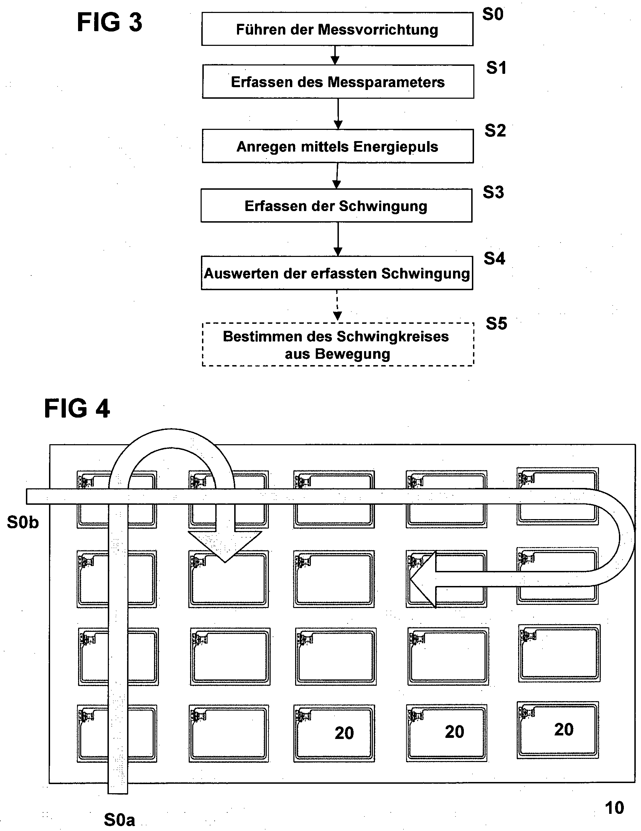

In Figur 4 sind beispielhaft zwei mögliche Bewegungsmuster der Messvorrichtung 100 dargestellt. Die Messvorrichtung wird zur Messung der Schwingkreise 20 nacheinander von Schwingkreis zu Schwingkreis geführt. Vorliegend sind die Schwingkreise wiederum auf einem Bogen 10 mit mehreren Schwingkreisen 20 angeordnet. In einem ersten Messvorgang für einen ersten Bogen 10 wird die Messvorrichtung 100 spaltenweise und mit wechselnder Richtung, also abwechselnd von unten nach oben und dann von oben nach unten, geführt S0a. In einem zweiten Messvorgang, für einen anderen Bogen 10, wird die Messvorrichtung zeilenweise und wieder mit wechselnder Richtung, also wechselnd von links nach rechts und dann von rechts nach links, geführt S0b.

Neben einer solchen mäanderförmigen Bewegung kann aber auch eine gleichgerichtete zeilenweise oder spaltenweise Bewegung erfolgen. Nicht vorbestimmte Bewegungen entstehen insbesondere bei Führung der Messvorrichtung durch einen Benutzer. Zudem müssen nicht immer alle Schwingkreise geprüft werden. Beispielsweise kann aus jeder Zeile und Spalte zufällig nur ein Schwingkreis geprüft werden.

In Figur 3 sind Schritte einer bevorzugten Ausführungsform eines Verfahrens zum Prüfen eines zur kontaktlosen Datenkommunikation eingerichteten Schaltkreises 20 angegeben.

In Schritt S0 wird die Messvorrichtung über einen Schwingkreis geführt. Ein durch die geführte Bewegung entstandener Messparameter wird in Schritt S1 erfasst. Beispielsweise erfasst ein Beschleunigungssensor anhand eines Beschleunigungswertes die Bewegung der Messvorrichtung.

In Schritt S2 wird der Schaltkreis 20 mittels eines Energiepulses angeregt. Dies kann mittels der Erregerspule 130 aus Figur 1 durch Zusammenwirken mit dem Impulsgeber 110 erfolgen. Das Anregen erfolgt vorzugsweise mittels eines gepulsten Magnetfeldes induktiv, wobei das Magnetfeld vorzugsweise durch einen einzelnen Strompuls in Form eines Dirac-Stoßes erzeugt wird.

In Schritt S3 wird die Schwingung des Schaltkreises 20 in Antwort auf das Anregen des Schaltkreises 20 erfasst. Dazu dient die Messantenne 140 aus Figur 1. Die erfasste Schwingung entspricht dabei einer freien, gedämpften Schwingung des Schaltkreises 20.

Die Schritte S0 bis S3 werden in einem Messvorgang für mehrere Schwingkreise nacheinander wiederholt ausgeführt. Die Schritte S0 bis S3 werden für jeden der weiteren zu messenden Schaltkreise ausgeführt. Der Messvorgang umfasst somit eine Messung für jeden Schaltkreis.

Die Auswertungseinheit 200 empfängt die erfasste Schwingung, als Messwerte, und zumindest einen Teil der Messparameter.

In Schritt S4 wird die erfasste Schwingung durch eine Auswertungseinrichtung, beispielsweise die Auswertungseinrichtung 200 aus Fig. 5, ausgewertet. Wie vorstehend beschrieben, kann in dieser Weise die Funktionsfähigkeit des Schaltkreises geprüft und insbesondere eine Eigenresonanzfrequenz und/oder eine Güte des Schaltkreises 20 ermittelt werden.

Nachdem mehrere Schaltkreise geprüft wurden, kann in der Auswertungseinheit anhand des erfassten Messparameters Beschleunigung das Bewegungsmuster im Sinne von Figur 4 bestimmt werden S5. Erst aus dem Messparameter ergibt sich also mit Sicherheit, welche erfasste Schwingung für welchen Schwingkreis auszuwerten ist. Alternativ dient der Messparameter Beschleunigung nur zum Abgleich des tatsächlichen Bewegungsmuster der Messvorrichtung mit einem vorgegebenen Bewegungsmuster.

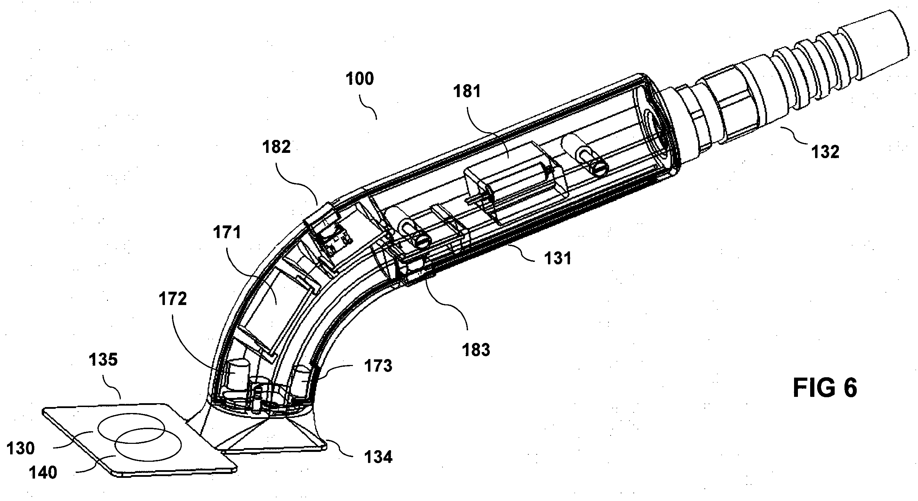

In Figur 6 sind die Komponenten der Messvorrichtung 100 genauer dargestellt. Der Antennenträger 135 mit der symbolisch dargestellten Erregerantenne 130 und er Messantenne 140 ist über einen Trägerhalter 134 (starr) mit einem Griff 131 verbunden. Der Griff 131 wird aus zwei Griffschalenhälften gebildet. Der ebenfalls am Griff angeschlossene Kabelanschluss 132 dient zur Aufnahme des flexiblen nicht dargestellten Verbindungskabels zur Auswertungseinheit.

In dem Griff 131 der Messvorrichtung 100 sind - möglichst nahe zu dem Antennenträger 135 - einer oder mehrere Sensoren 171, 172, 173 zur Erfassung von Messparametern vorgesehen. Ein Beschleunigungssensor 171 erfasst die Beschleunigung beim Führen der Messvorrichtung 100 zu dem zu prüfenden Schwingkreis. Die erfassten Beschleunigungswerte werden der Auswertungseinheit bereitgestellt.

Ein Abstandssensor 172 und /oder ein Lagesensor 173 sind im Bereich des Trägerhalters angeordnet. Sie können beispielsweise zusammen mit dem Impulsgeber und den Verstärkern aus Figur 1 auf einer Platine angeordnet werden. Der Abstandssensor 172 erfasst den Abstand zum Schaltkreis. Der Lagesensor erfasst die Lage der Ebene des Antennenträgers 135 relativ zur Ebene des Schaltkreises (bzw. zur Ebene der Antenne des Schaltkreises). Die erfassten Messparameter können an die Auswertungseinheit übertragen werden und /oder als Basis für eine Rückmeldung an der Messvorrichtung dienen.

Die Messvorrichtung umfasst ferner mindestens eine Rückmeldeeinheit 181, 182 sowie einen Taster 183 als Eingabemittel. Der Taster 183 kann zur manuellen Auslösung einer Messung (Schritte S2 und S3) dienen. Die Rückmeldeeinheit 181 ist eine mechanische Rückmeldeeinheit, insbesondere in der Form eines Vibrationselements. Die Rückmeldeeinheit 182 ist eine optische Rückmeldeeinheit, insbesondere in der Form einer farbigen LED. Die Rückmeldeeinheit 182 kann zugleich als Taster ausgebildet sein.

Erkennt die Messvorrichtung 100 (oder die Auswertungseinheit 200), dass die Lage und / oder der Abstand der Messvorrichtung zum Schaltkreis anzupassen ist, kann eine Rückmeldung mittels der Rückmeldeeinheiten 181, 182 erfolgen. Der die Messvorrichtung führende Benutzer kann die Führung der Messvorrichtung 100 nach einer Rückmeldung anpassen. Eine die Messvorrichtung führende Einheit könnte ein Steuersignal als entsprechende Rückmeldung auswerten. Eine Rückmeldung mittels einer Rückmeldeeinheit 181, 182 kann von der Auswertungseinheit 200 beispielsweise angestoßen werden, wenn die Auswertung ein negatives Prüfungsergebnis (Schaltkreis defekt bzw. nicht im Normalbereich) ergibt. Ebenso könnte die Auswertungseinheit 200 über eine andere Rückmeldung mittels einer Rückmeldeeinheit 181, 182 eine erneute Messung eines Schaltkreises anfordern (Schaltkreis evtl. defekt bzw. zweideutiges Prüfungsergebnis bei erfasstem Messparameter).

An eine Auswertungseinheit können mehrere Messvorrichtungen eines Produktionssystems angeschlossen sein.

In einem Produktionssystem mit mehreren Messvorrichtungen werden diese insbesondere den gleichen Schwingkreis mehrfach vor und/oder nach unterschiedlichen Produktionsschritten messen. Beispielsweise kann ein Schwingkreis vor und nach dem Verbinden des Bauelements (Chip) mit der Antenne geprüft werden. Der gleiche Schwingkreis wird dann beispielsweise von einer weiteren Messvorrichtung nach einer Integration in einen tragbaren Datenträger geprüft (z.b. nach der Lamination des Trägers mitsamt Schaltkreis als Inlay in den Kartenkörper).

Die beschriebene Messvorrichtung ist eingerichtet, um eine Eigenschaft eines zur kontaktlosen Datenkommunikation vorgesehenen Schwingkreises zu messen.

Im Folgenden wird eine eigenständige vorteilhafte Anwendung des Messprinzips mit den Schritten S2 bis S4 aus Figur 3 auf ein anderes Messobjekt, das insbesondere keine eigene Induktivität bzw. Spule aufweist, dargestellt.

Das andere Messobjekt kann beispielsweise eine vorhandene leitfähige Fläche, eine kapazitive Koppelfläche, ein Anschluss eines Schaltkreises an ein Modul (Chipmodul) oder an eine Kontaktfläche, oder ein Anschluss des Schaltkreises an eine Zusatzeinheit, wie Display, Taster oder Batterie, sein. Das andere Messobjekt weist keine wesentliche eigene Induktivität, also insbesondere keine Spule, auf. Für einen Messvorgang mit den Schritten S2 bis S4 aus Figur 3 wird das Messobjekt temporär durch eine Induktivität ergänzt. Das Messobjekt und die ergänzte Induktivität bilden einen Schwingkreis aus, dessen Schwingung erfasst werden kann. Die ergänzende Induktivität besteht vorzugsweise aus einer Antenne bzw. Spule.

Die ergänzende Induktivität wird vorzugsweise kontaktlos zu dem Messobjekt ergänzt. Wenn die ergänzende Induktivität neben der Induktivität (Spule) eine kapazitive Koppelfläche aufweist, kann eine kapazitive Einkopplung an eine vorhandene, leitende Fläche des Messobjekts erfolgen. Alternativ könnte auch eine kontaktierende Ergänzung erfolgen, insbesondere an eine auf dem Messobjekt verfügbaren, von außen kontaktierbaren, Anschluss, wie beispielsweise eine der Kontaktflächen C1 bis C6 (oder bis C8) eines Chipmoduls im Sinne von ISO 7816. Die Kontaktflächen können für die Ergänzung ebenfalls als kapazitive Koppelfläche dienen.

Auf diesem Weg kann eine Eigenschaft des Messobjektes (Größe der Fläche oder unterbrechungsfreier Anschluss) mit der gleichen Messvorrichtung gemessen werden, wie ein zur kontaktlosen Datenkommunikation vorgesehener Schwingkreis.

In einem Produktionssystem kann eine Messvorrichtung mit einer Induktivität ergänzte Messobjekte und zur kontaktlosen Datenkommunikation vorgesehene Schwingkreise messen. Auf einem Datenträger können sowohl ein mit einer Induktivität zu ergänzendes Messobjekt als auch ein zur kontaktlosen Datenkommunikation vorgesehener Schwingkreis vorliegen. In einem Produktionssystem können mehrere Messvorrichtungen mehrfach nacheinander den gleichen Datenträger messen und dabei zumindest einmal das mit einer Induktivität ergänzte Messobjekt des Datenträgers und zumindest einmal den zur kontaktlosen Datenkommunikation vorgesehenen Schwingkreis des Datenträgers messen. Eine Messvorrichtung kann optional eine Einheit zur Ergänzung der Induktivität umfassen, also beispielsweise eine Ergänzungsantenne mit zumindest einer damit verbundenen Koppelfläche.

Insbesondere im Rahmen von mechanischen Tests (Biegetest, Klopftest oder Rütteltest) oder thermischen Tests (Temperaturofen, Wechselbelastung...) kann mehrfach (oder sogar kontinuierlich) kontaktlos gemessen werden. Es wird somit erkennbar, beispielsweise bei welchem Biegewinkel, ein Defekt auftritt, also beispielsweise der Anschluss von der Kontaktfläche (oder kapazitiven Koppelfläche) des Datenträgers zum Chip (oder zu einer Zusatzeinheit) unterbrochen wird. Unabhängig von einer zusätzlichen Belastung können Anschlussfehler auf diesem Weg erkannt werden, die ansonsten nur durch kontaktierende Prüfung oder nur nach dem Ende des ganzen oder zumindest teilweisen Belastungstest erkennbar wären.

Vorteilhaft an dem Prüfverfahren ist zudem, dass für den Mess- oder Prüfvorgang kein nennenswerter Strom fließt. Somit werden insbesondere Effekte vermieden, in welchen ein Stromfluss während des Prüfvorgangs eine Randbedingung der Prüfung und damit das Prüfungsergebnis beeinflusst.

**Patentansprüche**

1. Verfahren zum Messen einer Eigenschaft eines zur kontaktlosen Datenkommunikation vorgesehenen Schwingkreises (20) mit einer Messvorrichtung (100), umfassend die Schritte:

   - Führen (S0) der Messvorrichtung (100) zu dem Schwingkreis (S1) hin;
- Anregen (S2) des Schwingkreises (20) durch die Messvorrichtung (100) mittels eines Energiepulses; und
- Erfassen (S3) einer abklingenden Schwingung des Schwingkreises (20) in Antwort auf die Anregung durch den Energiepuls mit der Messvorrichtung (100),

**gekennzeichnet durch**

- Erfassen (S1) eines durch das Führen der Messvorrichtung (100) entstandenen Messparameters, wobei der Messparameter eine Bewegung der Messvorrichtung (100) ist.

2. Verfahren nach Anspruch 1, **gekennzeichnet durch**

- Auswerten (S4) der erfassten Schwingung des Schwingkreises (20) hinsichtlich der Eigenschaft des Schwingkreises (20).

3. Verfahren nach Anspruch 1 oder 2, **dadurch gekennzeichnet, dass** in einem Messvorgang die Eigenschaft für mehrere Schwingkreise jeweils nacheinander mit den Teilmessschritten des Führens (S0), Anregens (S2) und Erfassens (S3) gemessen wird.

4. Verfahren nach einem der Ansprüche 1 bis 3, **dadurch gekennzeichnet, dass** Abweichungen der Bewegung der Messvorrichtung von einer linearen Bewegung erfasst werden.

5. Verfahren nach einem der Ansprüche 1 bis 4, **dadurch gekennzeichnet, dass** mittels der erfassten Bewegung der gemessene Schwingkreis aus mehreren Schwingkreisen bestimmt wird (S5).

6. Verfahren nach einem der Ansprüche 1 bis 5, **dadurch gekennzeichnet, dass** in dem Schritt des Auswertens (S4) der Messparameter berücksichtigt wird.

7. Verfahren nach einem der Ansprüche 1 bis 6, **dadurch gekennzeichnet, dass** der Messparameter verwendet wird, um ein Rückmeldungssignal zu erzeugen.

8. Verfahren nach einem der Ansprüche 1 bis 7, **dadurch gekennzeichnet, dass** das Anregen des Schwingkreises (20) als induktives Anregen mittels eines gepulsten Magnetfeldes erfolgt, wobei das Magnetfeld vorzugsweise durch einen einzelnen Strompuls erzeugt wird und/oder wobei der Strompuls vorzugsweise als Gleichstrompuls in Form eines Dirac-Stoßes erzeugt wird.

9. Verfahren nach einem der Ansprüche 1 bis 8, **dadurch gekennzeichnet, dass** das Anregen des Schwingkreises (20) kontaktlos mittels einer Erregerantenne (130) durchgeführt wird und/oder dass das Erfassen der Schwingung des Schwingkreises (20) kontaktlos mittels einer Messantenne (140) durchgeführt wird.

10. Messvorrichtung (100) zum Messen eines zur kontaktlosen Datenkommunikation eingerichteten Schwingkreises (20), wobei die Messvorrichtung (100) umfasst:

- einen Griff (131), welcher für das Messen einer Eigenschaft des Schwingkreises die Führung der Messvorrichtung (100) zu dem Schwingkreis (20) ermöglicht;
- eine Erregerantenne (130) für ein kontaktloses Anregen des Schwingkreises; und
- eine Messantenne (140), die eingerichtet ist, eine abklingende Schwingung des Schwingkreises (20) in Antwort auf die Anregung mittels der Erregerantenne (130) zu erfassen,

**gekennzeichnet durch**

- einen Sensor (171, 172, 173) zur Erfassung eines durch die Führung der Messvorrichtung (100) entstandenen Messparameters umfasst und/oder
- eine Rückmeldeeinheit (181, 182), welche eine Rückmeldung als Steuersignal oder als für einen Benutzer wahrnehmbares Signal erzeugt, wobei die Rückmeldung die geführte Bewegung der Messeinheit betrifft.

11. Mess- und Auswertungsvorrichtung (300) mit einer Messvorrichtung (100) nach Anspruch 10, **gekennzeichnet durch** eine Auswertungseinheit (200), welche eingerichtet ist, die von der Messantenne (140) erfasste Schwingung des Schaltkreises (20) auszuwerten, wobei die Auswertungseinheit (200) vorzugsweise unabhängig von der Messvorrichtung (100) bewegt werden kann.

**Claims**

1. A method for measuring a property of an oscillating circuit (20), provided for the contactless data communication, having a measuring apparatus (100), comprising the steps:

- guiding (S0) the measuring apparatus (100) to the oscillating circuit (S1);
- exciting (S2) the oscillating circuit (20) by the measuring apparatus (100) by means of an energy pulse; and

- capturing (S3) with the measuring apparatus (100) a decaying oscillation of the oscillating circuit (20) in response to the excitation by the energy pulse,

**characterized by**

- capturing (S1) a measurement parameter resulting from the guiding of the measuring apparatus (100), wherein the measurement parameter is a motion of the measuring apparatus (100).

2. The method according to claim 1, **characterized by**

- evaluating (S4) the captured oscillation of the oscillating circuit (20) with regard to the property of the oscillating circuit (20).

3. The method according to claim 1 or 2, **characterized in that** in a measurement process the property is measured for several oscillating circuits respectively successively with the partial measurement steps of guiding (S0), exciting (S2) and capturing (S3).

4. The method according to any of claims 1 to 3, **characterized in that** deviations of the motion of the measuring apparatus from a linear motion are captured.

5. The method according to any of claims 1 to 4, **characterized in that** the measured oscillating circuit is determined (S5) from several oscillating circuits by means of the captured motion.

6. The method according to any of claims 1 to 5, **characterized in that** the measurement parameter is taken into consideration in the evaluating step (S4).

7. The method according to any of claims 1 to 6, **characterized in that** the measurement parameter is employed to generate a feedback signal.

8. The method according to any of claims 1 to 7, **characterized in that** the exciting of the oscillating circuit (20) is effected as an inductive exciting by means of a pulsed magnetic field, wherein the magnetic field is preferably generated by an individual current pulse and/or wherein the current pulse is preferably generated as a direct current pulse in the form of a Dirac impulse.

9. The method according to any of claims 1 to 8, **characterized in that** the exciting of the oscillating circuit (20) is carried out contactlessly by means of an exciter antenna (130), and/or that the capturing of the oscillation of the oscillating circuit (20) is carried out contactlessly by means of a measuring antenna (140).

10. A measuring apparatus (100) for measuring an oscillating circuit devised for the contactless data communication (20), wherein the measuring apparatus (100) comprises:

- a handle (131) which enables the guiding of the measuring apparatus (100) to the oscillating circuit (20) for the measuring of a property of the oscillating circuit;
- an exciter antenna (130) for a contactless exciting of the oscillating circuit; and
- a measuring antenna (140) which is devised to capture a decaying oscillation of the oscillating circuit (20) in response to the excitation by means of the exciter antenna (130),

**characterized by**

- a sensor (171, 172,173) for capturing a measurement parameter resulting from the guiding of the measuring apparatus (100) and/or
- a revertive communication unit (181, 182) which generates a feedback as a control signal or as a signal perceptible to a user, wherein the feedback concerns the controlled motion of the measurement module.

11. A measuring and analysis apparatus (300) having a measuring apparatus (100) according to claim 10, **characterized by** an analysis unit (200) which is devised to evaluate captured oscillations of the circuit (20) captured by the measuring antenna (140), wherein the analysis unit (200) can preferably be moved independently of the measuring apparatus (100).

**Revendications**

1. Procédé de mesure d'une propriété d'un circuit oscillant (20), prévu pour la communication de données sans contact, avec un dispositif de mesure (100), comprenant les étapes :

- guidage (S0) du dispositif de mesure (100) vers le circuit oscillant (S1) ;
- excitation (S2) du circuit oscillant (20) par le dispositif de mesure (100) au moyen d'une impulsion d'énergie ; et
- saisie (S3) d'une oscillation évanescente du circuit oscillant (20) en réponse à l'excitation par l'impulsion d'énergie, par le dispositif de mesure (100),

**caractérisé par**

EP 2 779 031 B1

- saisie (S1) d'un paramètre de mesure engendré par le guidage du dispositif de mesure (100), cependant que le paramètre de mesure est un mouvement du dispositif de mesure (100).

2. Procédé selon la revendication 1, **caractérisé par**

    - évaluation (S4) de l'oscillation saisie du circuit oscillant (20) quant à la propriété du circuit oscillant (20).

3. Procédé selon la revendication 1 ou 2, **caractérisé en ce que,** dans une opération de mesure, la propriété est mesurée pour plusieurs circuits oscillants, respectivement les uns après les autres, avec les étapes de mesure partielles du guidage (S0), de l'excitation (S2) et de la saisie (S3).

4. Procédé selon une des revendications de 1 à 3, **caractérisé en ce que** des écarts du mouvement du dispositif de mesure par rapport à un mouvement linéaire sont saisis.

5. Procédé selon une des revendications de 1 à 4, **caractérisé en ce que,** au moyen du mouvement saisi, le circuit oscillant mesuré est déterminé (S5) à partir de plusieurs circuits oscillants.

6. Procédé selon une des revendications de 1 à 5, **caractérisé en ce que,** dans l'étape de l'évaluation (S4), le paramètre de mesure est pris en compte.

7. Procédé selon une des revendications de 1 à 6, **caractérisé en ce que** le paramètre de mesure est utilisé pour générer un rétro-signal.

8. Procédé selon une des revendications de 1 à 7, **caractérisé en ce que** l'excitation du circuit oscillant (20) a lieu en tant qu'excitation par induction au moyen d'un champ magnétique pulsé, cependant que le champ magnétique est de préférence généré par une impulsion individuelle de courant, et/ou cependant que l'impulsion de courant est générée de préférence en tant qu'impulsion de courant continu sous forme d'une impulsion de Dirac.

9. Procédé selon une des revendications de 1 à 8, **caractérisé en ce que** l'excitation du circuit oscillant (20) est effectuée sans contact au moyen d'une antenne d'excitation (130), et/ou que la saisie de l'oscillation du circuit oscillant (20) est effectuée sans contact au moyen d'une antenne de mesure (140).

10. Dispositif de mesure (100) destiné à la mesure d'un circuit oscillant (20) conçu pour la communication de données sans contact, cependant que le dispositif de mesure (100) comprend :

    - une manette (131) qui, pour la mesure d'une propriété du circuit oscillant, permet le guidage du dispositif de mesure (100) au circuit oscillant (20) ;
    - une antenne d'excitation (130) pour une excitation sans contact du circuit oscillant ; et
    - une antenne de mesure (140) conçue pour saisir une oscillation évanescente du circuit oscillant (20) en réponse à l'excitation au moyen de l'antenne d'excitation (130),

    **caractérisé par**

    - un capteur (171, 172, 173) pour la saisie d'un paramètre de mesure engendré par le guidage du dispositif de mesure (100), et/ou
    - une unité de rétrosignalisation (181, 182) qui génère une réaction sous forme de signal de commande ou de signal perceptible pour un utilisateur, cependant que la réaction concerne le mouvement guidé de l'unité de mesure.

11. Dispositif de mesure et d'évaluation (300) ayant un dispositif de mesure(100) selon la revendication 10, **caractérisé par** une unité d'évaluation (200) conçue pour évaluer l'oscillation du circuit oscillant (20) saisie par l'antenne de mesure (140), cependant que l'unité d'évaluation (200) peut être déplacée de préférence indépendamment du dispositif de mesure (100).

**FIG 1**

160

155   150

20   22

24

140   130

120   110

**FIG 2**

$A_0$

$A = A_0 e^{-\delta t}$

$A_n$

$A_{n+1}$

t

$A = A_0 \exp(-\delta t) \cos \omega t$

**FIG 3**

| | |
|---|---|
| Führen der Messvorrichtung | S0 |
| Erfassen des Messparameters | S1 |
| Anregen mittels Energiepuls | S2 |
| Erfassen der Schwingung | S3 |
| Auswerten der erfassten Schwingung | S4 |
| Bestimmen des Schwingkreises aus Bewegung | S5 |

**FIG 4**

S0b

20    20    20

S0a

10

200

210

300

100

135

10

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0289830 A2
- US 2012264373 A1

**In der Beschreibung aufgeführte Nicht-Patentliteratur**

- RFID-Handbuch. Carl Hanser Verlag, 2012